(19) **Europäisches Patentamt**
**European Patent Office**
**Office européen des brevets**

(11) **EP 1 780 891 B1**

(12) **EUROPÄISCHE PATENTSCHRIFT**

| | |
|---|---|
| (45) Veröffentlichungstag und Bekanntmachung des Hinweises auf die Patenterteilung: **27.02.2008 Patentblatt 2008/09** | (51) Int Cl.: **H03H 17/02** *(2006.01)* |

(21) Anmeldenummer: **06015165.1**

(22) Anmeldetag: **20.07.2006**

(54) **Digitale Filterkaskade mit einem während des Einschwingvorgangs bandbreitenerhöhten Filter**

Digital filter cascade with a filter having its bandwidth broadened during transient period

Cascade de filtres numériques comprenant un filtre dont sa bande passante est élargie pendant la période transitoire

(84) Benannte Vertragsstaaten:
**DE FR GB**

(30) Priorität: **20.10.2005 DE 102005050309**

(43) Veröffentlichungstag der Anmeldung:
**02.05.2007 Patentblatt 2007/18**

(73) Patentinhaber: **Rohde & Schwarz GmbH & Co. KG**
**81671 München (DE)**

(72) Erfinder:
• **Nitsch, Bernhard, Dr.**
**80687 München (DE)**

• **Renardy, Paul**
**81927 München (DE)**

(74) Vertreter: **Körfer, Thomas et al**
**Mitscherlich & Partner**
**Patent- und Rechtsanwälte**
**Postfach 33 06 09**
**80066 München (DE)**

(56) Entgegenhaltungen:
**EP-A2- 1 026 824       WO-A-03/019534**
**DE-A1- 10 009 767**

**Beschreibung**

Die Erfindung betrifft eine digitale Filterkaskade mit einem während des Einschwingvorgangs bandbreitenerhöhten Filter.

Digitale Signalverarbeitungsstrecken, wie sie beispielsweise in Spektrumanalysatoren zum Einsatz kommen, enthalten eine digitale Filterkaskade aus mehreren seriell verschalteten digitalen Filtern, die eine für ihre jeweilige Funktion sinnvolle Filterstruktur aufweisen.

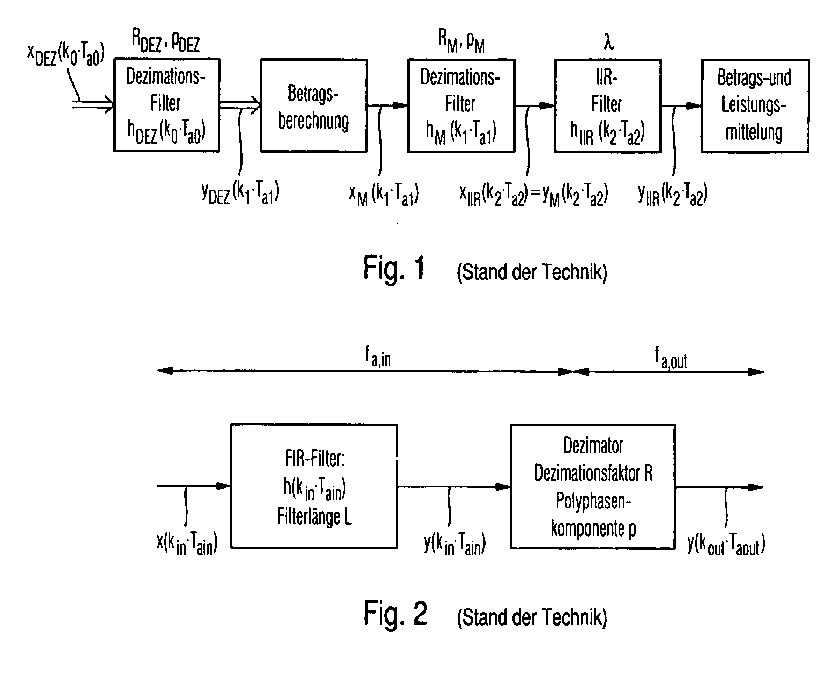

Fig. 1 zeigt eine derartige digitale Filterkaskade für den Empfangskanal eines Spektrumanalysators. Am Eingang dieser digitalen Filterkaskade liegt das empfangene komplexwertige Basisbandsignal $x_{DEZ}(k_0 \cdot T_{a0})$ mit der hohen Abtastfrequenz $l/T_{a0}$ an, das in einem ersten dezimierenden Filter - mit der Impulsantwort $h_{DEZ}(k_0.T_{a0})$, der Filterlänge $L_{DEZ}$, dem Dezimationsfaktor $R_{DEZ}$ und der Polyphasenkomponente $p_{DEZ}$ - in ein Ausgangssignal $y_{DEZ}(k_1 \cdot T_{a1})$ mit einer niedrigeren Abtastfrequenz $l/T_{a1}$ gewandelt wird, anschließend einer Betragsbildung zugeführt wird und schließlich in einem zweiten dezimierenden Filter - mit der Impulsantwort $h_M(k_1 \cdot T_{a1})$, der Filterlänge $L_M$, dem Dezimationsfaktor $R_M$ und der Polyphasenkomponente $p_M$ - in ein Ausgangssignal $y_M(k_2 \cdot T_{a2})$ mit einer gegenüber der niedrigeren Abtastfrequenz $l/T_{a1}$ zusätzlich reduzierten Abtastfrequenz $l/T_{a2}$ übergeführt wird. Das im zweiten dezimierenden Filter erzeugte Ausgangssignal $y_M(k_2 \cdot T_{a2})$ stellt das Eingangssignal $X_{IIR}(k_2 \cdot T_{a2})$ eines Infinite-Impulse-Response-Filters (IIR-Filter) mit der Impulsantwort $h_{IIR}(k_2 \cdot T_{a2})$ und dem Gedächtnisfaktor $\lambda$ dar, das im Meßsignal auftretende Störsignalanteile unterdrückt. Das Ausgangssignal $y_{IIR}(k_2 \cdot T_{a2})$ wird schließlich am Ende der digitalen Filterkaskade einer Betrags-Leistungsmittelung unterworfen.

Das erste und zweite dezimierende Filter wird durch ein systemtheoretisches Ersatzschaltbild gemäß Fig. 2 bestehend aus typischerweise einem nicht dezimierenden Filter mit der Impulsantwort $h(k_0 \cdot Ta_0)$ und der Filterlänge L und einem idealen Polyphasendezimator mit dem Dezimationsfaktor R und der Polyphasenkomponente p modelliert. Als dezimierendes Filter wird typischerweise ein Finite-Impulse-Response-Filter (FIR-Filter) eingesetzt. Alternativ kann auch ein Infinite-Impulse-Response-Filter (IIR-Filter) oder ein Cascaded-Integrator-Comb-Filter (CIC-Filter) zum Einsatz kommen.

Das nicht dezimierende Filter des ersten bzw. zweiten dezimierenden Filters erzeugt aus einem Eingangssignal $x(k_{in} \cdot T_{ain})$ mittels Faltung mit der Impulsantwort $h(k_{in} \cdot T_{ain})$ gemäß Gleichung (1) ein Ausgangssignal $y(k_{in} \cdot T_{ain})$:

$$y(k_{in} \cdot T_{ain}) = \sum_{\xi=0}^{L-1} h(\xi \cdot T_{ain}) \cdot x((k_{in} - \xi) \cdot T_{ain}) \qquad (1)$$

Der ideale Polyphasendezimator des ersten bzw. zweiten dezimierenden Filters erzeugt gemäß Gleichung (2) aus seinem Eingangssignal $y(k_{in} \cdot T_{ain})$ mit der Abtastrate $l/T_{ain}$ mittels der Polyphasenkomponente p und des gemäß Gleichung (3) definierten Dezimationsfaktor R ein Ausgangssignal $y(k_{out} \cdot T_{aout})$ mit der Abtastrate $1/T_{aout}$:

$$y(k_{out} \cdot T_{aout}) = y((k_{out} \cdot R + p) \cdot T_{ain}) \qquad (2)$$

$$R = \frac{T_{aout}}{T_{ain}} \qquad (3)$$

Das IIR-Filter ist typischerweise als IIR-Filter erster Ordnung ausgeführt, das aus seinem Eingangssignal $X_{IIR}(k_2 \cdot T_{a2})$ gemäß Gleichung (4) das Ausgangssignal $y_{IIR}(k_2 \cdot T_{a2})$ erzeugt.

$$y_{IIR}(k_2 \cdot T_{a2}) = (1 - \lambda) \cdot y_{IIR}((k_2 - 1) \cdot T_{a2}) + \lambda \cdot x_{IIR}(k_2 \cdot T_{a2}) \qquad (4)$$

Der Gedächtnisfaktor $\lambda$ bestimmt dabei die Bandbreite B und somit die Einschwingzeit T des IIR-Filters, wobei zwischen dem Gedächtnisfaktor $\lambda$ und der Einschwingzeit T des IIR-Filters erster Ordnung eine indirekte Proportionalität besteht.

Der Einschwingzustand des Ausgangssignals $y_{IIR}(k_2 \cdot T_{a2})$ der digitalen Filterkaskade wird durch den Einschwingzustand des Eingangssignals $x_{DEZ}(k_0 \cdot T_{a0})$ der digitalen Filterkaskade und durch das dynamische Übertragungsverhalten der einzelnen Filter der digitalen Filterkaskade, beschrieben durch die jeweiligen Impulsantworten $h(k_0 \cdot T_{a0})$, $h_M(k_1 \cdot T_{a1})$ und $h_{IIR}(k_2 \cdot T_{a2})$ der einzelnen Filter, bestimmt.

Im hier betrachteten Fall liegen die Bandbreiten $B_{FIR}$ der dezimierenden Filter, welche mit ihren jeweiligen Impulsantworten $h(k_0 \cdot T_{a0})$ und $h_M(k_1 \cdot T_{a1})$ typischerweise als FIR-Filter ausgeführt sind, in einer höheren Größenordnung als die Bandbreite $B_{IIR}$ des IIR-Filters am Ende der digitalen Filterkaskade. Somit wird die Einschwingzeit der gesamten digitalen Filterkaskade durch die deutlich schlechtere Einschwingzeit des IIR-Filters nachteilig reduziert.

WO 03/019534 offenbart eine digitale Filterkaskade mit zwei Filtern. Während des Einschwingvorgangs der Filterkaskade weist das vorausgehende Filter eine reduzierte und das nachfolgende Filter eine höhere Bandbreite aus.

Aufgabe der Erfindung ist es deshalb, die Einschwingzeit einer digitalen Filterkaskade mit mehreren digitalen Einzelfiltern zu minimieren.

Die Aufgabe der Erfindung wird durch eine digitale Filterkaskade mit den Merkmalen des Anspruchs 1. Die abhängigen Ansprüche enthalten vorteilhafte Weiterbildungen der Erfindung.

Da ein IIR-Filter bekannterweise eine gute Stördynamik aufweist und somit im Meßsignal enthaltene Störsignalanteile sehr schnell und sehr gut dämpfen kann und gleichzeitig, wie oben erwähnt, eine vergleichsweise schlechte Führungsdynamik besitzt und somit einem veränderten Pegel eines Meßsignals vergleichsweise langsam folgt, wird erfindungsgemäß eine Umschaltung zwischen einer ersten Filterstruktur - IIR-Filter - während des stationären Betriebs der digitalen Filterkaskade und einer zweiten Filterstruktur - modifiziertes IIR-Filter - während des Einschwingvorgangs der digitalen Filterkaskade mit einer gegenüber dem ersten Filterstruktur erhöhten Bandbreite $B_{up}$ verwirklicht. Auf diese Weise wird die gute Stördynamik des IIR-Filters während des stationären Betriebs der digitalen Filterkaskade mit einer guten Führungsdynamik eines modifizierten IIR-Filters während des Einschwingvorgangs der digitalen Filterkaskade kombiniert.

Die erhöhte Bandbreite $B_{up}$ und damit die minimierte Einschwingzeit T des modifizierten IIR-Filters während des Einschwingvorgangs der digitalen Filterkaskade wird dadurch realisiert, dass der mit dem Gedächtnisfaktor $\lambda$ gewichtete Abtastwert $y_{IIR}((k_2-1) \cdot T_{a2})$ des Ausgangssignals des IIR-Filters zum Abtastzeitpunkt $(k_2-1) \cdot T_{a2}$ der Gleichung (4) im modifizierten IIR-Filter im Rahmen der Strukturumschaltung des IIR-Filters nicht mehr zurückgekoppelt wird. Somit entsteht während des Zeitraums des Einschwingvorgangs der digitalen Filterkaskade ein modifiziertes IIR-Filter, dessen Einschwingverhalten dem eines FIR-Filters höherer Ordnung entspricht und damit gegenüber dem Einschwingverhalten des reinen IIR-Filters verbessert ist.

Eine Strukturumschaltung vom reinen IIR-Filter zum modifizierten IIR-Filter zu Beginn des Einschwingvorgangs der digitalen Filterkaskade setzt einen stationären Einschwingzustand des Eingangssignals des IIR-Filters voraus.

Der gültige Einschwingzustand des Eingangssignals des IIR-Filters wird von einer Einheit zur Steuersignal-Erzeugung in Abhängigkeit eines gültigen - eingeschwungenen - Eingangssignals der digitalen Filterkaskade und des Einschwingverhaltens sämtlicher dem IIR-Filter vorausgehenden Filter ermittelt und dem IIR-Filter mittels eines Steuersignals signalisiert. Das Einschwingverhalten der vorausgehenden Filter, die im allgemeinen dezimierende Filter darstellen, ergibt sich aus der jeweiligen Filterlänge L des nicht dezimierenden Filteranteils - typischerweise ein FIR-Filter - und des jeweiligen Dezimationsfaktors R und der jeweiligen Polyphasenkomponente p des sich an das FIR-Filter jeweils anschließenden Polyphasendezimator.

In einer ersten Ausführungsform der erfindungsgemäßen Filterkaskade wird für jedes einzelnen Dezimationsfilter jeweils eine Untereinheit zur Steuersignal-Erzeugung mit anschließen Polyphasendezimator und in einer zweiten Ausführungsform der erfindungsgemäßen Filterkaskade für alle Dezimationsfilter zusammen eine Untereinheit zur Steuersignal-Erzeugung mit anschließenden Polyphasendezimator vorgehalten.

Werden die Polyphasendezimatoren der einzelnen Dezimationsfilter zurückgesetzt, so werden die dadurch verursachten Verzögerungen in der Filterkaskade auch in der Einheit zur Steuersignal-Erzeugung bei der Berechnung der einzelnen Steuersignale an den Ausgängen der einzelnen Polyphasendezimatoren berücksichtigt. Wird zusätzlich durch Rücksetzen der nicht dezimierenden FIR-Filter in den einzelnen Dezimationsfiltern das Einschwingverhalten der digitalen Filterkaskade verzögert, so werden diese zeitlichen Verzögerungen auch bei der Berechnung der einzelnen Steuersignale der Untereinheiten zur Steuersignal-Erzeugung einbezogen.

Ausführungsbeispiele der erfindungsgemäßen Filterkaskade und des erfindungsgemäßen digitalen Filters werden im Folgenden unter Berücksichtigung der Zeichnung näher erläutert. In der Zeichnung zeigen:

Fig. 1    ein Blockschaltbild einer digitalen Filter kaskade mit digitalen Einzelfiltern unterschiedlicher Bandbreite nach dem Stand der Technik,

Fig. 2    Einzelfilters nach dem Stand der Technik,

Fig. 3    ein Bockschaltbild eines erfindungsgemäßen digitalen Filters,

Fig. 4 ein Blockschaltbild einer ersten Ausführungsform einer erfindungsgemäßen digitalen Filterkaskade, das ein erfindungsgemäßes digitales Filter enthält,

Fig. 5 ein Zustandsdiagramm für die Strukturumschaltung der erfindungsgemäßen digitalen Filterkaskade und

Fig. 6 ein Blockschaltbild einer zweiten Ausführungsform der erfindungsgemäßen digitalen Filterkaskade, das ein erfindungsgemäßes digitales Filter enthält.

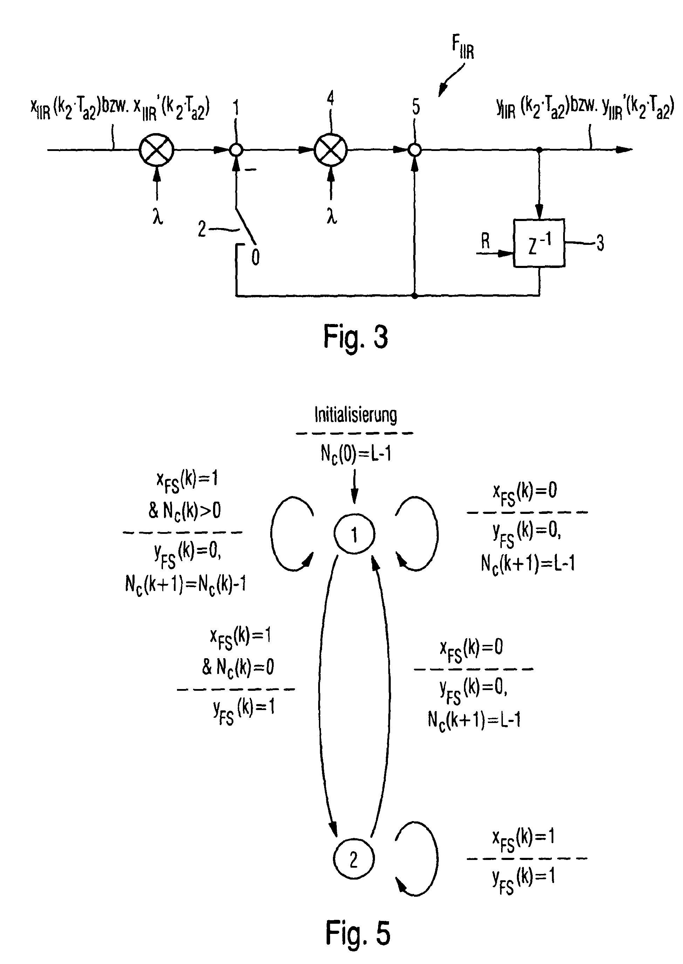

Bevor anhand der Fig. 3 bis 5 die Struktur und Funktionsweise der erfindungsgemäßen digitalen Filterkaskade und des erfindungsgemäßen digitalen Filters erläutert wird, werden im folgenden die mathematischen Grundlagen der Erfindung vorgestellt.

Die Impulsantwort $h_{IIR}(k_2 \cdot T_{a2})$ eines IIR-Filters 1. Ordnung, dessen Übertragungsverhalten durch Gleichung (4) beschrieben ist, ergibt sich gemäß Gleichung (5), wie aus der einschlägigen Fachliteratur zu entnehmen ist:

$$h_{IIR}(k_2 \cdot T_{a2}) = \begin{cases} \lambda \cdot (1-\lambda)^{k_2} & k_2 \geq 0 \\ 0 & k_2 = 0 \end{cases} \qquad (5)$$

Die Sprungantwort $h_{IIR,sprung}(k_2 \cdot T_{a2})$ eines IIR-Filters 1. Ordnung kann ebenfalls in der einschlägigen Fachliteratur nachgelesen werden und ergibt sich gemäß Gleichung (6):

$$h_{IIR,sprung}(k_2 \cdot T_{a2}) = \sum_{\zeta=0}^{k_2} \lambda \cdot (1-\lambda)^{\zeta} = 1 - (1-\lambda)^{k_2+1} \qquad (6)$$

Wird Gleichung (6) für die Sprungantwort $h_{IIR,sprung}(k_2 \cdot T_{a2})$ des IIR-Filters 1. Ordnung auf den Wert $\alpha$ gesetzt und anschließend Gleichung (6) nach $k_2$ umgeformt, so ergibt sich gemäß Gleichung (7) die Anzahl $k_{IIR}$ von Abtastwerten, bis das Ausgangssignal des IIR-Filters 1. Ordnung nach einer Sprunganregung den Wert $\alpha$ erreicht bzw. überschreitet.

$$k_{IIR} = \left\lceil \frac{\log(1-\alpha)}{\log(1-\lambda)} \right\rceil - 1 \qquad (7)$$

Eine Beschleunigung des Einschwingverhaltens des IIR-Filters 1. Ordnung kann herbeigeführt werden, indem in der Filtercharakteristik gemäß Gleichung (4) das mit dem Gedächtnisfaktor $\lambda$ gewichtete Ausgangssignal $y_{IIR}((k_2-1) \cdot T_{a2})$ des IIR-Filters 1. Ordnung zum Abtastzeitpunkt $(k_2-1) \cdot T_{a2}$ nicht zurückgekoppelt wird. Die zu einem derart modifizierten IIR-Filter 1. Ordnung gehörige Filtercharakteristik ist durch Gleichung (8) beschrieben:

$$y_{IIR}{}'(k_2 \cdot T_{a2}) = y_{IIR}{}'((k_2-1) \cdot T_{a2}) + \lambda \cdot x_{IIR}{}'(k_2 \cdot T_{a2}) \qquad (8)$$

Die Filtercharakteristik von Gleichung (8) entspricht der Filtercharakteristik eines FIR-Filters höherer Ordnung im Zeitraum seines Einschwingvorgangs über insgesamt $S$ Abtastzeitpunkte. Ein derartiges FIR-Filter höherer Ordnung weist eine Impulsantwort $h_{FIR}(k_2 \cdot T_{\alpha2})$ gemäß Gleichung (9) und eine Sprungantwort $h_{FIR,sprung}(k_2 \cdot T_{\alpha,2})$ gemäß Gleichung (10) auf, wie ebenfalls in der einschlägigen Fachliteratur nachzuschlagen ist.

$$h_{FIR}(k_2 \cdot T_{a2}) = \begin{cases} \lambda & 0 \leq k_2 \leq S \\ 0 & sonst \end{cases} \qquad (9)$$

$$h_{FIR,sprung}(k_2 \cdot T_{a,2}) = \lambda \cdot k_2 \qquad\qquad (10)$$

Wird Gleichung (10) für die Sprungantwort $h_{FIR,sprung}(k_2 \cdot T_{a,2})$ für ein FIR-Filter höherer Ordnung auf den Wert $\alpha$ gesetzt und anschließend Gleichung (10) nach $k_2$ umgeformt, so ergibt sich gemäß Gleichung (11) die Anzahl $K_{FIR}$ von Abtastwerten, bis das Ausgangssignal des FIR-Filters höherer Ordnung nach einer Sprunganregung den Wert $\alpha$ erreicht bzw. überschreitet.

$$k_{FIR} = \left\lceil \frac{\alpha}{\lambda} \right\rceil \qquad\qquad (11)$$

Wird das IIR-Filter 1. Ordnung mit seiner Filtercharakteristik gemäß Gleichung (4) während seines Einschwingvorgangs über insgesamt $S$ Abtastzeitpunkte in ein modifiziertes IIR-Filter 1. Ordnung mit einer Filtercharakteristik gemäß Gleichung (8) umgeschaltet, so ergibt sich durch diese Strukturumschaltung ein Gewinn $\dfrac{k_{IIR}}{k_{FIR}}$ im Einschwingverhalten gemäß Gleichung (12):

$$\frac{k_{IIR}}{k_{FIR}} = \frac{\left\lceil \dfrac{\log(1-\alpha)}{\log(1-\lambda)} \right\rceil - 1}{\left\lceil \dfrac{\alpha}{\lambda} \right\rceil} \qquad\qquad (12)$$

Setzt man in Gleichung (11) $\alpha = 1$, so ergibt sich für das modifizierte IIR-Filter 1. Ordnung eine minimale Einschwingzeit nach insgesamt $S_{min}$ Abtastzeitpunkten gemäß Gleichung (13).

$$S_{min} = \left\lfloor \frac{1}{\lambda} \right\rfloor \qquad\qquad (13)$$

Nach insgesamt $S_{min}$ Abtastzeitpunkten wird das modifizierte IIR-Filter 1. Ordnung gemäß Gleichung (8) wieder in das IIR-Filter 1. Ordnung gemäß Gleichung (4) zurückgeschaltet.

Ein erfindungsgemäßes Filter, das mittels Strukturumschaltung zwischen einem IIR-Filter 1. Ordnung gemäß Gleichung (4) und einem modifizierten IIR-Filter 1. Ordnung gemäß Gleichung (8) umschaltbar ist, ist in Fig. 3 dargestellt.

Am Eingang liegt das abgetastete Eingangssignal $x_{IIR}(k_2 \cdot T_{a2})$ bzw. $x_{IIR}'(k_2 \cdot T_{a2})$ an, das über ein Summierglied 1 in der Betriebsart des IIR-Filters über den Schalter 2 mit dem im Verzögerungsglied 3 um eine Abtastzeit $T_{a2}$ zeitlich verzögerten Ausgangssignal $y_{IIR}((k_2-1) \cdot T_{a2})$ additiv verknüpft wird und in der Betriebsart des modifizierten IIR-Filters über den Schalter 2 mit dem Wert "0" verknüpft wird. Über das Multiplizierglied 4 wird das Signal am Ausgang des Summiergliedes 1 mit dem Gedächtnisfaktor $\lambda$ gewichtet und in einem weiteren Summierglied 5 mit dem im Verzögerungsglied 3 um eine Abtastzeit $T_{a2}$ zeitlich verzögerten Ausgangssignal $y_{IIR}((k_2-1) \cdot T_{a2})$ in der Betriebsart des IIR-Filters und mit dem im Verzögerungsglied 3 um eine Abtastzeit $T_{a2}$ zeitlich verzögerten Ausgangssignal $y_{IIR}'((k_2-1) \cdot T_{a2})$ in der Betriebsart des modifizierten IIR-Filters additiv verknüpft. Das Ausgangssignal des Summiergliedes 5 stellt das Aus-gangssignal $y_{IIR}(k_2 \cdot T_{a2})$ des als IIR-Filters arbeitenden erfindungsgemäßen digitalen Filters bzw. das Ausgangssignal $y_{IIR}'(k_2 \cdot T_{a2})$ des als modifiziertes IIR-Filter arbeitenden erfindungsgemäßen digitalen Filters dar. Zum Zeitpunkt der Strukturumschaltung vom IIR-Filter zum modifizierten IIR-Filter wird der Ausgang des Verzögerungsglieds 3 über den Reset-Eingang R zurückgesetzt.

Eine Strukturumschaltung zwischen dem als IIR-Filter und dem als modifiziertes IIR-Filter arbeitenden erfindungsgemäßen digitalen Filters innerhalb der erfindungsgemäßen digitalen Filterkaskade setzt ein stationäres - einge-

schwungenes Eingangssignal $x_{IIR}(k_2 \cdot T_{a2})$ bzw. $x_{IIR}(k_2 \cdot T_{a2})$ am Eingang des digitalen Filters voraus. Dies setzt ein eingeschwungenes Ausgangssignal $y_M(k_2 \cdot T_{a2})$ am Ende aller vorausgehenden Einzelfilter der digitalen Filterkaskade voraus. Dieser stationäre eingeschwungene Zustand des Ausgangssignal $y_M(k_2 \cdot T_{a2})$ am Ende aller vorausgehenden Einzelfilter der digitalen Filterkaskade ist von einem eingeschwungenen Zustand des Eingangssignals $x_{DEZ}(k_0 \cdot T_{a0})$ am Eingang der digitalen Filterkaskade und vom Einschwingverhalten jedes einzelnen vorausgehenden Filters der digitalen Filterkaskade abhängig.

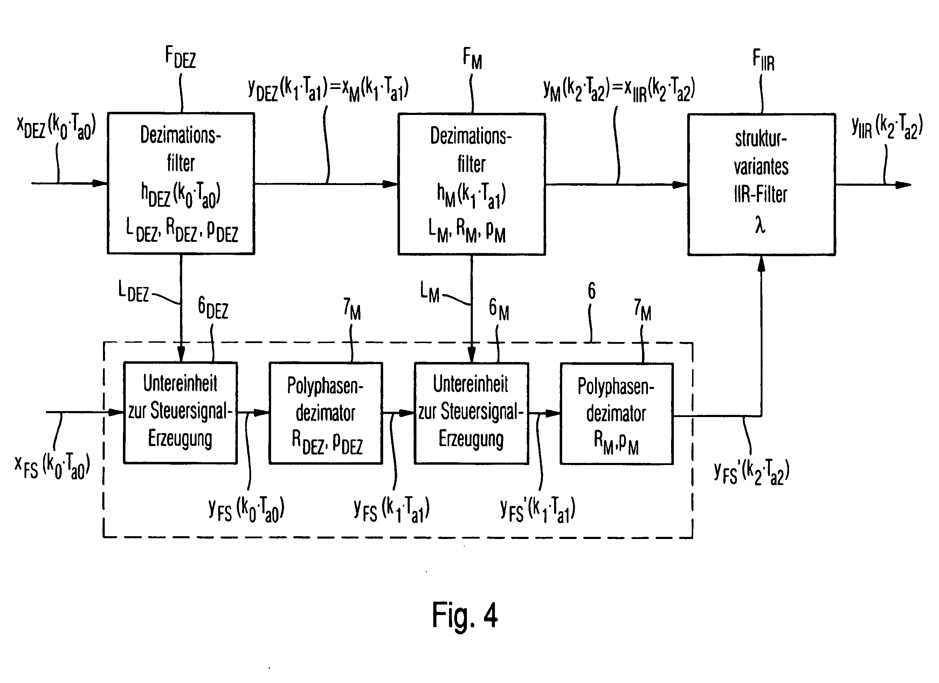

In der ersten Ausführungsform der erfindungsgemäßen digitalen Filterkaskade gemäß Fig. 4 wird dem erfindungsgemäßen digitalen Filter über ein von einer Einheit zur Steuersignal-Erzeugung 6 generiertes Steuersignal $y_{FS}(k_2 \cdot T_{a2})$ der eingeschwungene Zustand des Ausgangssignals $y_M(k_2 \cdot T_{a2})$ am Ende aller vorausgehenden Einzelfilter der digitalen Filterkaskade signalisiert. Die Einheit zur Steuersignal-Erzeugung 6 besteht für jedes vorausgehende Filter jeweils aus einer Untereinheit zur Steuersignal-Erzeugung $6_{DEZ}$, $6_M$ usw. und für den Fall eines dezimierenden vorausgehenden Filters zusätzlich aus einem Polyphasendezimator $7_{DEZ}$, $7_M$ usw..

Der Untereinheit zur Steuersignal-Erzeugung $6_{DEZ}$ wird das Steuersignal $X_{FS}(k_0 \cdot T_{a0})$ zugeführt, das die Gültigkeit des Eingangssignals $X_{DEZ}(k_0 \cdot T_{a0})$ der digitalen Filterkaskade mit einem aktivierten Pegel (Pegelzustand: "1") signalisiert, und berechnet das Steuersignal $y_{FS}(k_0 \cdot T_{a0})$, das ab dem Zeitpunkt des eingeschwungenen Zustand des nicht dezimierenden Filteranteils - FIR-Filter mit der Filterlänge $L_{DEZ}$ - des ersten vorausgehenden dezimierenden Filters $F_{DEZ}$ aktiviert ist. Das Steuersignal $y_{FS}(k_0 \cdot T_{a0})$ wird folglich von der Untereinheit zur Steuersignal-Erzeugung $6_{DEZ}$ nach insgesamt $L_{DEZ}$-1 Abtastzeitpunkten - die Einschwingzeit des FIR-Filters mit der Filterlänge $L_{DEZ}$ - seit Anregung mit einem aktivierten Steuersignal $x_{FS}(k_0 \cdot T_{a0})$ aktiviert (Pegelzustand: "1").

Das Steuersignal $y_{FS}(k_0 \cdot T_{a0})$ wird anschließend im Polyphasendezimator $7_{DEZ}$, der den identischen Dezimationsfaktor $R_{DEZ}$ und die identische Polyphasenkomponente $p_{DEZ}$ zum ersten vorausgehenden dezimierenden Filters $F_{DEZ}$ aufweist, in ein Steuersignal $y_{FS}(k_1 \cdot T_{a1})$ mit reduzierter Abtastrate $f_{a1}$ gewandelt.

Anschließend berechnet die Untereinheit zur Steuersignal-Erzeugung $6_M$ aus dem Steuersignal $y_{FS}(k_1 \cdot T_{a1})$ das Steuersignal $y_{FS}'(k_1 \cdot T_{a1})$, das ab dem Zeitpunkt des eingeschwungenen Zustand des nicht dezimierenden Filteranteils - FIR-Filter mit der Filterlänge $L_M$ - des zweiten vorausgehenden dezimierenden Filters $F_M$ aktiviert ist. Das Steuersignal $y_{FS}'(k_1 \cdot T_{a1})$ wird folglich von der Untereinheit zur Steuersignal-Erzeugung $6_M$ nach insgesamt $L_M$-1 Abtastzeitpunkten - die Einschwingzeit des FIR-Filters mit der Filterlänge $L_M$ - seit Anregung mit dem Steuersignal $y_{FS}'(k_1 \cdot T_{a1})$ aktiviert (Pegelzustand:"1").

Schließlich wird das Steuersignal $y_{FS}'(k_1 \cdot T_{a1})$ anschließend im Polyphasendezimator $7_M$, der den identischen Dezimationsfaktor $R_M$ und die identische Polyphasenkomponente $p_M$ zum zweiten vorausgehenden dezimierenden Filters $F_M$ aufweist, in ein Steuersignal $y_{FS}'(k_2 \cdot T_{a2})$ mit reduzierter Abtastrate $f_{a2}$ gewandelt, das dem erfindungsgemäßen digitalen Filter $F_{IIR}$ zugeführt wird.

Sobald das Steuersignal $y_{FS}'(k_2 \cdot T_{a2})$ aktiviert ist, ist das Ausgangssignals $y_M(k_2 \cdot T_{a2})$ am Ende aller vorausgehenden Einzelfilter $F_{DEZ}$, $F_M$ usw. der digitalen Filterkaskade und damit das Eingangssignal $x_{IIR}(k_2 \cdot T_{a2})$ bzw. $x_{IIR}'(k_2 \cdot T_{a2})$ am Eingang des erfindungsgemäßen digitalen Filters - strukturvariantes IIR-Filter - eingeschwungen.

Die Deaktivierung des Steuersignals $y_{FS}(k_0 \cdot T_{a0})$ (Pegelzustand: "0") durch die Untereinheit zur Steuersignal-Erzeugung $6_{DEZ}$ erfolgt, sobald das Eingangssignal $X_{DEZ}(k_0 \cdot T_{a0})$ ungültig ist (deaktiviertes Steuersignal $x_{FS}(k_0 \cdot T_{a0})$ (Pegelzustand:"0")). Analog wird das Steuersignal $y_{FS}'(k_1 \cdot T_{a1})$ durch die Untereinheit zur Steuersignal-Erzeugung $6_M$ deaktiviert, sobald das Eingangssignal $y_{FS}(k_1 \cdot T_{a1})$ deaktiviert ist.

Die Funktionsweise der Untereinheit zur Steuersignal-Erzeugung $6_{DEZ}$ bzw. $6_M$ ist stellvertretend am Beispiel der Untereinheit zur Steuersignal-Erzeugung $6_{DEZ}$ im Zustandsdiagramm der Fig. 5 dargestellt. Die Untereinheit zur Steuersignal-Erzeugung $6_{DEZ}$ verwendet zur Aktivierung des Steuersignals $y_{FS}(k_0 \cdot T_{a0})$ einen Zähler, dessen Zählerstand $N_c(0)$ zu Beginn mit der um den Faktor 1 dekrementierten Filterlänge $L_{DEZ}$ initialisiert wird und mit Eintreten eines gültigen Eingangssignals - Steuersignal $X_{Fs}(k_0-T_{a0})$ ist aktiviert - dekrementiert wird. Sobald der Zählerstand $N_c$ den Wert "0" erreicht hat, wird das Steuersignal $y_{FS}(k_0 \cdot T_{a0})$ am Ausgang der Untereinheit zur Steuersignal-Erzeugung $6_{DEZ}$ aktiviert. Mit Auftreten eines ungültigen Eingangssignals $x_{DEZ}(k_0 \cdot T_{a0})$ am Eingang der digitalen Filterkaskade - deaktiviertes Steuersignal $y_{FS}(k_0 \cdot T_{a0})$ - wird das Steuersignal $y_{FS}(k_0 \cdot T_{a0})$ deaktiviert und der Zählerstand $N_c$ wieder auf die um den Faktor 1 dekrementierte Filterlänge $L_{DEZ}$ initialisiert.

Bei aktivierten Steuersignal $y_{FS}'(k_2 \cdot T_{a2})$ und damit eingeschwungenen Eingangssignal $x_{IIR}(k_2 \cdot T_{a2})$ am Eingang des erfindungsgemäßen digitalen Filters wird mit Einsetzen einer Anregung des erfindungsgemäßen digitalen Filters - strukturvariantes IIR-Filter $F_{IIR}$ - durch das Ausgangssignal $y_M(k_2 \cdot T_{a2})$ am Ende aller vorausgehenden Einzelfilter $F_{DEZ}$, $F_M$ usw. der digitalen Filterkaskade der Schalter 2 in die Schalterstellung des Signalwertes "0" gelegt und über den Reset-Eingang R der Ausgang des Verzögerungsgliedes 3 zurückgesetzt. Auf diese Weise ist im erfindungsgemäßen digitalen Filter $F_{IIR}$ eine Strukturumschaltung vom IIR-Filter - erste Filterstruktur - zum modifizierten IIR-Filter - zweite Filterstruktur - erfolgt. Über insgesamt S Abtastzeitpunkten weist das erfindungsgemäße digitale Filter FIIR eine höhere Bandbreite $B_{up}$ und damit eine niedrigere Einschwingzeit T auf, bis der Einschwingvorgang abgeschlossen ist und das erfindungsgemäße digitale Filter $F_{IIR}$ über den Schalter 2 vom modifizierten IIR-Filter - zweite Filterstruktur - wieder zum IIR-Filter - erste Filterstruktur - umgeschaltet wird.

**EP 1 780 891 B1**

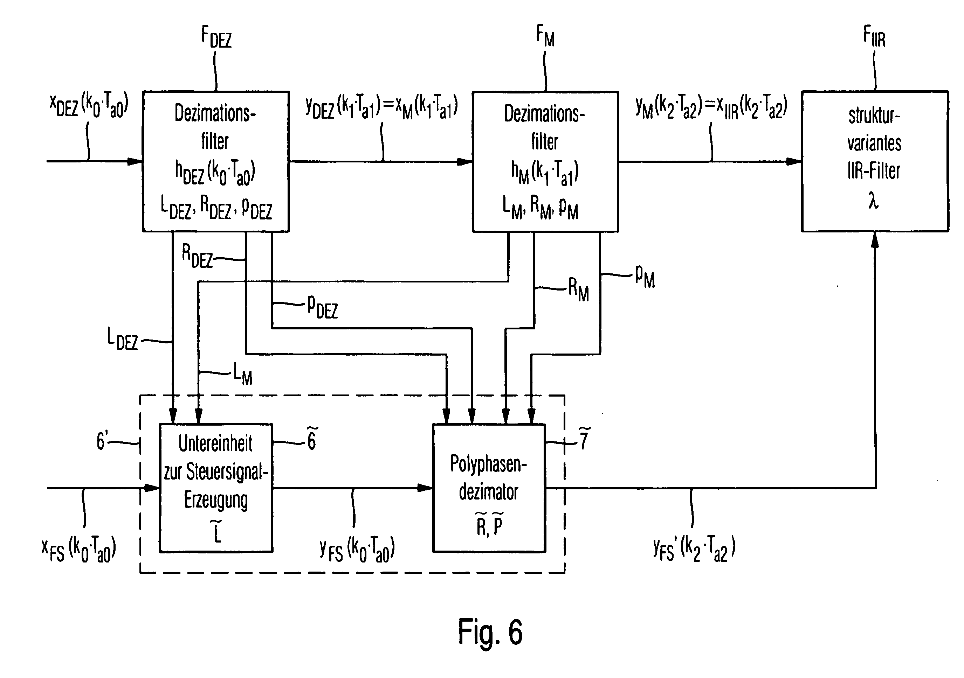

In der zweiten Ausführungsform der erfindungsgemäßen Filterkaskade in Fig. 6 besteht die Einheit zur Steuersignal-Erzeugung 6' aus einer einzigen Untereinheit zur Steuersignal-Erzeugung $\tilde{6}$, die ausgehend von der Filterlänge $L_{DEZ}$ des ersten Dezimationsfilters $F_{DEZ}$ und der Filterlänge $L_M$ des zweiten Dezimationsfilters $F_M$ die Ersatzfilterlänge $\tilde{L}$ des aus ersten und zweiten Dezimationsfilter $F_{DEZ}$ und $F_M$ zusammengesetzten Ersatz-Dezimationsfilters ermittelt und das Steuersignal $y_{FS}(k_0 \cdot T_{a0})$ nach insgesamt $\tilde{L}$-1 Abtastzeitpunkten seit Anregung mit dem Steuersignal $x_{FS}(k_0 \cdot T_{a0})$ aktiviert.

Das Steuersignal $y_{FS}(k_0 \cdot T_{a0})$ wird anschließend im Polyphasendezimator $\tilde{7}$, der einen aus dem Dezimationsfaktor $R_{DEZ}$ des ersten Dezimationsfilter $F_{DEZ}$ und dem Dezimationsfaktor $R_m$ des zweiten Dezimationsfilter $F_M$ zusammengesetzten Dezimationsfaktor $\tilde{R}$ und eine aus der Polyphasenkomponente $p_{DEZ}$ des ersten Dezimationsfaktor $F_{DEZ}$ und der Polyphasenkomponente $p_m$ ermittelte Polyphasenkomponente $\tilde{p}$ aufweist, in ein Steuersignal $y_{FS}'(k_2 \cdot T_{a2})$ mit reduzierter Abtastrate $f_{a2}$ gewandelt.

Im Fall eines Rücksetzens der Dezimationsfilter $F_{DEZ}$ und $F_M$ werden, falls einzig die Polyphasendezimatoren der Dezimationsfilter $F_{DEZ}$ und $F_M$ zurückgesetzt werden und deshalb die Abtastwerte der zugehörigen Ausgangssignale $y_{DEZ}(k_1 \cdot T_{a1})$ bzw. $y_M(k_2 \cdot T_{a2})$ zeitlich verzögert ausgegeben werden, auch die von den Polyphasendezimatoren $7_{DEZ}$, $7_M$ bzw. 7 der Einheit zur Steuersignal-Erzeugung 6 bzw. 6' erzeugten Abtastwerte der zugehörigen Steuersignale $y_{FS}(k_1 \cdot T_{a1})$ bzw. $y_{FS}'(k_1 \cdot T_{a1})$ in der gleichen Größenordnung zeitlich verzögert ausgegeben.

Werden in den Dezimationsfiltern $F_{DEZ}$ und $F_M$ zusätzlich auch die nicht dezimierenden FIR-Filter zurückgesetzt und damit der Einschwingvorgang der Dezimationsfilter $F_{DEZ}$ und $F_M$ beeinflußt, so ist dies bei der Ermittlung der Steuersignale $y_{FS}(k_0 \cdot T_{a0})$ und $y_{FS}'(k_1 \cdot T_{a1})$ bzw. $y_{FS}'(k_2 \cdot T_{a2})$ der Untereinheiten zur Steuersignal-Erzeugung $6_{DEZ}$ und $6_M$ bzw. $\tilde{6}$ auch zu berücksichtigen.

Die Erfindung ist nicht auf die dargestellten Ausführungsformen beschränkt. Von der Erfindung sind neben IIR-Filter 1. Ordnung auch IIR-Filter höherer Ordnung sowie andere digitale Filterstrukturen, die eine gegenüber FIR-Filtern niedrigere Bandbreite aufweisen, beispielsweise CIC-Filter und vorgelagerte IIR-Filter, abgedeckt. Zusätzlich schließt die Erfindung auch Filterkaskaden mit mehreren seriell und/oder parallel verschalteten vorausgehenden dezimierenden und/oder nicht dezimierenden digitalen Filtern ein. Die zugehörigen Einheiten zur Steuersignal-Erzeugung sind in diesem Fall an die jeweilige Filterkaskadenstruktur anzupassen.

**Patentansprüche**

1.   Digitale Filterkaskade mit einem mindestens einem vorausgehenden Filter ($F_{DEZ}$, $F_M$) nachfolgenden Filter ($F_{IIR}$), das außerhalb eines Einschwingvorgangs eine gegenüber den vorausgehenden Filtern ($F_{DEZ}$, $F_M$) reduzierte Bandbreite aufweist,
wobei das nachfolgende Filter ($F_{IIR}$) während des Einschwingvorgangs der Filterkaskade eine höhere Bandbreite ($B_{up}$) aufweist,
**dadurch gekennzeichnet,**
**dass** die höhere Bandbreite ($B_{up}$) des nachfolgenden Filters ($F_{IIR}$) während des Einschwingvorgangs der Filterkaskade mittels Umschaltung von einer ersten Filterstruktur auf eine zweite Filterstruktur des nachfolgenden Filters ($F_{IIR}$) herbeigeführt wird.

2.   Digitale Filterkaskade nach Anspruch 1,
**dadurch gekennzeichnet,**
**dass** die erste Filterstruktur des nachfolgenden Filters ($F_{IIR}$) ein Infinite-Impulse-Response-Filter 1. Ordnung ist, dessen Ausgangssignal $y_{IIR}(k_2 \cdot T_{a2})$ sich nach folgender Gleichung berechnet:

$$y_{IIR}(k_2 \cdot T_{a2}) = (1 - \lambda) \cdot y_{IIR}((k_2 - 1) \cdot T_{a2}) + \lambda \cdot x_{IIR}(k_2 \cdot T_{a2})$$

wobei

λ der Gedächtnisfaktor der Filterstruktur,
$x_{IIR}(k_2 \cdot T_{a2})$ das Eingangssignal der ersten Filterstruktur und
$k_2 \cdot T_{a2}$ bzw. $(k_2-1) \cdot T_{a2}$ die Abtastzeitpunkte des Ein- und Ausgangssignals der ersten Filterstruktur sind.

3.   Digitale Filterkaskade nach Anspruch 2,
**dadurch gekennzeichnet,**

**dass** die zweite Filterstruktur des nachfolgenden Filters ($F_{IIR}$) ein modifiziertes Infinite-Impulse-Response-Filter 1. Ordnung ist.

**4.** Digitale Filterkaskade nach Anspruch 2 oder 3,
**dadurch gekennzeichnet,**
**dass** das um den Gedächtnisfaktor λ gewichtete Ausgangssignal $y_{IIR}((k_2-1)·T_{a2})$ der ersten Filterstruktur zum Abtastzeitpunkt $(k_2-1)·T_{a2}$ in der zweiten Filterstruktur nicht zurückgekoppelt ist.

**5.** Digitale Filterkaskade nach Anspruch 4,
**dadurch gekennzeichnet,**
**dass** das Ausgangssignal $y_{IIR}'((k_2-1)·T_{a2})$ der zweiten Filterstruktur des nachfolgenden Filters ($F_{IIR}$) sich nach folgender Gleichung berechnet:

$$y_{IIR}'(k_2 · T_{a2}) = y_{IIR}'((k_2 - 1) · T_{a2}) + \lambda · x_{IIR}'(k_2 · T_{a2})$$

wobei

λ der Gedächtnisfaktor der Filterstruktur,
$x_{IIR}(k_2·T_{a2})$ das Eingangssignal der zweiten Filterstruktur und
$k_2·T_{a2}$ bzw. $(k_2-1)·T_{a2}$ die Abtastzeitpunkte des Ein- und Ausgangssignals der zweiten Filterstruktur sind.

**6.** Digitale Filterkaskade nach einem der Ansprüche 1 bis 5,
**dadurch gekennzeichnet,**
**dass** die Umschaltung von der ersten zur zweiten Filterstruktur des nachfolgenden Filters ($F_{IIR}$) erst im Fall eines eingeschwungenen Eingangssignals ($x_{IIR}(k_2·T_{a2}),x_{IIR}'(k_2·T_{a2})$) des nachfolgenden Filters ($F_{IIR}$) freigegeben ist.

**7.** Digitale Filterkaskade nach Anspruch 6,
**dadurch gekennzeichnet,**
**dass** ein Steuersignal ($y_{FS}'(k_2·T_{a2})$) dem nachfolgenden Filter ($F_{IIR}$) den Zeitpunkt signalisiert, in dem sein Eingangssignal ($x_{IIR}(k_2·T_{a2}),x_{IIR}'(k_2·T_{a2})$) eingeschwungen ist.

**8.** Digitale Filterkaskade nach Anspruch 7,
**dadurch gekennzeichnet,**
**dass** die vorausgehenden Filter ($F_{DEZ}$, $F_M$) der digitalen Filterkaskade jeweils aus einem nicht dezimierenden Filter oder einem dezimierenden Filter besteht, wobei sich das dezimierende Filter aus einer Serienschaltung eines nicht dezimierenden Filters und eines Polyphasendezimators zusammensetzt.

**9.** Digitale Filterkaskade nach Anspruch 8,
**dadurch gekennzeichnet,**
**dass** das jeweilige nicht dezimierende Filter ein Finite-Impulse-Response-Filter, ein Infinite-Impulse-Response-Filter oder ein Cascaded-Integrator-Comb-Filter mit jeweils einer Filterlänge L ist.

**10.** Digitale Filterkaskade nach Anspruch 8 oder 9,
**dadurch gekennzeichnet,**
**dass** der jeweilige Polyphasendezimator eine einschwingoptimierte Polyphasenkomponente (p) und einen Dezimationsfaktor (R) aufweist.

**11.** Digitale Filterkaskade nach einem der Ansprüche 7 bis 10,
**dadurch gekennzeichnet,**
**dass** eine Einheit zur Steuersignal-Erzeugung (6,6') im Fall eines eingeschwungenen Eingangssignals $x(k_0,T_{a0})$ der digitalen Filterkaskade in Abhängigkeit der Filterlänge ($L_{DEZ},L_M$) der einzelnen nicht dezimierenden Filter und des Dezimationsfaktors ($R_{DEZ},R_M$) und der Polyphasenkomponente ($p_{DEZ},p_M$) der einzelnen Polyphasendezimatoren der digitalen Filterkaskade den Zeitpunkt des eingeschwungenen Eingangssignals ($x_{IIR}(k_2·T_{a2})$, $x_{IIR}'(k_2·T_{a2})$) des nachfolgenden Filters ($F_{IIR}$) ermittelt und das Steuersignal ($y_{FS}'(k_2·T_{a2})$) zur Signalisierung des Zeitpunkts des eingeschwungenen Eingangssignals ($x_{IIR}(k_2·T_{a2}),x_{IIR}'(k_2·T_{a2})$) des nachfolgenden Filters ($F_{IIR}$) erzeugt.

**12.** Digitale Filterkaskade nach Anspruch 11,
**dadurch gekennzeichnet,**
**dass** die Einheit zur Steuersignal-Erzeugung (6,6') im Fall eines Rücksetzens der nicht dezimierenden Filter und/ oder der Polyphasendezimatoren der vorausgehenden Filter ($F_{DEZ}$,$F_M$) der digitalen Filterkaskade den modifizierten Zeitpunkt des eingeschwungenen Eingangssignals ($x_{IIR}(k_2 \cdot T_{a2})$,$x_{IIR}'(k_2 \cdot T_{a2})$) des nachfolgenden Filters ($F_{IIR}$) ermittelt und das Steuersignal ($y_{FS}'$ ($k_2 \cdot T_{a2}$)) zur Signalisierung des modifizierten Zeitpunkts des eingeschwungenen Eingangssignals ($x_{IIR}(k_2 \cdot T_{\alpha2})$,$x_{IIR}'(k_2 \cdot T_{\alpha2})$) des nachfolgenden Filters ($F_{IIR}$) erzeugt.

**13.** Digitale Filterkaskade nach einem der Ansprüche 1 bis 12,
**dadurch gekennzeichnet,**
**dass** die Umschaltung von der zweiten zur ersten Filterstruktur des nachfolgenden Filters ($F_{IIR}$) erfolgt, sobald das modifizierte Infinite-Impulse-Response-Filter 1. Ordnung nach einer minimalen Einschwingzeit ($S \cdot T_{a2}$) einge- schwungen ist, wobei ($S$) die minimale Anzahl von Abtastzeitpunkten ist.

**14.** Digitale Filterkaskade nach Anspruch 13,
**dadurch gekennzeichnet,**

**dass** die minimale Anzahl ($S_{min}$) von Abtastzeitpunkten der ganzzahligen Inversen ($\left\lfloor \dfrac{1}{\lambda} \cdot \right\rfloor$) des Gedächtnisfaktors

($\lambda$) entspricht .


**Claims**

**1.** Digital filter cascade with a subsequent filter ($F_{IIR}$) following at least one preceding filter ($F_{DEZ}$, $F_M$), which, outside a transient-recovery process, provides a reduced bandwidth by comparison with the preceding filter ($F_{DEZ}$, $F_M$), wherein the subsequent filter ($F_{IIR}$) provides a higher bandwidth ($B_{up}$) during the transient recovery of the filter cascade,
**characterised in that**
the higher bandwidth ($B_{up}$) of the subsequent filter ($F_{IIR}$) during the transient recovery of the filter cascade is brought about by switching from a first filter structure to a second filter structure of the subsequent filter ($F_{IIR}$).

**2.** Digital filter cascade according to claim 1,
**characterised in that**
the first filter structure of the subsequent filter ($F_{IIR}$) is a first-order, infinite-impulse-response filter, of which the output signal $y_{IIR}(k_2 \cdot T_{a2})$ is calculated according to the following equation:

$$y_{IIR}(k_2 \cdot T_{a2}) = (1 - \lambda) \cdot y_{IIR}((k_2 - 1) \cdot T_{a2}) + \lambda \cdot x_{IIR}(k_2 \cdot T_{a2})$$

where

$\lambda$ denotes the memory factor of the filter structure,
$x_{IIR}(k_2 \cdot T_{a2})$ denotes the input signal of the first filter structure, and
$k_2 \cdot T_{a2}$ or $(k_2 - 1) \cdot T_{a2}$ denotes the sampling times of the input and output signal of the first filter structure.

**3.** Digital filter cascade according to claim 2,
**characterised in that**
the second filter structure of the subsequent filter ($F_{IIR}$) is a modified, first-order, infinite-impulse-response filter.

**4.** Digital filter cascade according to claim 2 or 3,
**characterised in that**
the output signal $y_{IIR}((k_2 - 1) \cdot T_{a2})$ of the first filter structure weighted by the memory factor $\lambda$ is not fed back into the second filter structure at the sampling time $(k_2 - 1) \cdot T_{a2}$.

5. Digital filter cascade according to claim 4,
   **characterised in that**
   the output signal $y_{IIR}'((k_2-1)\cdot T_{a2})$ of the second filter structure of the subsequent filter ($F_{IIR}$) is calculated according to the following equation:

$$y_{IIR}{}'(k_2 \cdot T_{a2}) = y_{IIR}{}'((k_2 - 1) \cdot T_{a2}) + \lambda \cdot x_{IIR}{}'(k_2 \cdot T_{a2})$$

where

   $\lambda$ denotes the memory factor of the filter structure,
   $X_{IIR}'(k_2 \cdot T_{a2})$ denotes the input signal of the second filter structure, and
   $k_2 \cdot T_{a2}$ or $(k_2\text{-}1)\cdot T_{a2}$ denotes the sampling times of the input and output signal of the second filter structure.

6. Digital filter cascade according to any one of claims 1 to 5,
   **characterised in that**
   the switching from the first to the second filter structure of the subsequent filter ($F_{IIR}$) is released only when the input signal ($x_{IIR}(k_2 \cdot T_{a2}), x_{IIR}'(k_2 \cdot T_{a2})$) of the subsequent filter ($F_{IIR}$) has recovered.

7. Digital filter cascade according to claim 6,
   **characterised in that**
   a control signal ($y_{FS}'(k_2 \cdot T_{a2})$) signals to the subsequent filter ($F_{IIR}$) the time, at which its input signal ($x_{IIR}(k_2 \cdot T_{a2})$, $x_{IIR}'(k_2 \cdot T_{a2})$) has recovered.

8. Digital filter cascade according to claim 7,
   **characterised in that**
   the preceding filters ($F_{DEZ}$, $F_M$) of the digital filter cascade consist respectively of a non-decimating filter or a decimating filter, wherein the decimating filter is composed of a series circuit of a non-decimating filter and a polyphase decimator.

9. Digital filter cascade according to claim 8,
   **characterised in that**
   the respective non-decimating filter is a finite-impulse-response filter, an infinite-impulse-response filter or a cascaded-integrator-comb filter with a filter length L in each case.

10. Digital filter cascade according to claim 8 or 9,
    **characterised in that**
    the respective polyphase decimator is a transient-recovery-optimised polyphase component (p) and provides a decimation factor (R).

11. Digital filter cascade according to any one of claims 7 to 10,
    **characterised in that**
    the unit for generating a control signal (6,6') in the event of a recovered input signal $x(k_0, T_{a0})$ of the digital filter cascade determines the transient-recovery time of the input signal ($x_{IIR}(k_2 \cdot T_{a2}), x_{IIR}'(k_2 \cdot T_{a2})$) of the subsequent filter ($F_{IIR}$) dependent upon the filter length ($L_{DEZ}, L_M$) of the individual, non-decimating filter and upon the decimation factor ($R_{DEZ}$, $R_M$) and the polyphase ($p_{DEZ}, p_M$) of the individual polyphase decimators of the digital filter cascade, and generates the control signal ($y_{FS}'(k_2 \cdot T_{a2})$) in order to signal the transient-recovery time of the input signal ($x_{IIR}(k_2 \cdot T_{a2})$, $X_{IIR}'(k_2 \cdot T_{a2})$) of the subsequent filter ($F_{IIR}$) .

12. Digital filter cascade according to claim 11,
    **characterised in that**
    the unit for generating a control signal (6,6') in the event of a resetting of the non-decimating filter and/or of the polyphase decimators of the preceding filter ($F_{DEZ}$, $F_M$) of the digital filter cascade determines the modified transient-recovery time of the input signal ($x_{IIR}(k_2 \cdot T_{a2}), x_{IIR}(k_2 \cdot T_{a2})$) of the subsequent filter ($F_{IIR}$) and generates the control signal ($y_{FS}'(k_2 \cdot Ta_2)$) in order to signal the modified transient-recovery time of the input signal ($x_{IIR}(k_2 \cdot T_{a2}), x_{IIR}'(k_2 \cdot T_{a2})$) of the subsequent filter ($F_{IIR}$).

13. Digital filter cascade according to any one of claims 1 to 12,
   **characterised in that**
   the switching from the second to the first filter structure of the subsequent filter ($F_{IIR}$) is implemented as soon as the modified, first-order infinite-impulse-response filter has recovered after a minimum transient-recovery time ($S \cdot T_{a2}$), wherein ($S$) is the minimum number of sampling times.

14. Digital filter cascade according to claim 13,
   **characterised in that**

   the minimum number ($S_{min}$) of sampling times corresponds to the inverse integer ( $\left\lfloor \dfrac{1}{\lambda} \right\rfloor$ ) of the memory factor ($\lambda$).

**Revendications**

1. Cascade de filtres numériques avec au moins un filtre ($F_{IIR}$) suivant un filtre précédent ($F_{DEZ}$, $F_M$), lequel comporte une bande passante réduite par rapport aux filtres ($F_{DEZ}$, $F_M$) précédents en dehors d'un phénomène transitoire, le filtre suivant ($F_{IIR}$) comportant une large bande passante ($B_{up}$) lors du phénomène transitoire de la cascade de filtres,
   **caractérisée en ce**
   **que** la large bande passante ($B_{up}$) du filtre suivant ($F_{IIR}$) est causée lors du phénomène transitoire de la cascade de filtres par la commutation d'une première structure de filtre sur une seconde structure de filtre du filtre suivant ($F_{IIR}$).

2. Cascade de filtres numériques selon la revendication 1,
   **caractérisée en ce**
   **que** la première structure de filtre du filtre suivant ($F_{IIR}$) est un filtre IIR (Infinite Impulse Response) de premier ordre, dont le signal de sortie $y_{IIR}(k_2 \cdot T_{a2})$ se calcule selon l'équation suivante :

   $$y_{IIR}(k_2 \cdot T_{a2}) = (1 - \lambda) \cdot y_{IIR}((k_2 - 1) \cdot T_{a2}) + \lambda \cdot x_{IIR}(k_2 \cdot T_{a2})$$

   où
   $\lambda$ est le coefficient de mémoire de la structure de filtre,
   $x_{IIR}(k_2 \cdot T_{a2})$ est le signal d'entrée de la première structure de filtre et
   $k_2 \cdot T_{a2}$ et/ou $(k_2\text{-}1) \cdot T_{a2}$ est le moment de balayage du signal d'entrée et du signal de sortie de la première structure de filtre.

3. Cascade de filtres numériques selon la revendication 2,
   **caractérisée en ce**
   **que** la seconde structure de filtre du filtre suivant ($F_{IIR}$) est un filtre IIR (Infinite Impulse Response) modifié de premier ordre.

4. Cascade de filtres numériques selon la revendication 2 ou 3,
   **caractérisée en ce**
   **que** le signal de sortie $y_{IIR}((k_2\text{-}1) \cdot T_{a2})$ de la première structure de filtre, pondéré autour du coefficient de mémoire $\lambda$ n'est pas couplé dans la seconde structure de filtre lors du moment de balayage $(k_2\text{-}1) \cdot T_{a2}$.

5. Cascade de filtres numériques selon la revendication 4,
   **caractérisée en ce**
   **que** le signal de sortie $y_{IIR}{}'((k_2\text{-}1) \cdot T_{a2})$ *de* la seconde structure de filtre du filtre suivant ($F_{IIR}$) se calcule selon l'équation suivante :

   $$y_{IIR}{}'(k_2 \cdot T_{a2}) = y_{IIR}{}'((k_2 - 1) \cdot T_{a2}) + \lambda \cdot x_{IIR}{}'(k_2 \cdot T_{a2})$$

où

$\lambda$ est le coefficient de mémoire de la structure de filtre,

$x_{IIR}'(k_2 \cdot T_{a2})$ est le signal d'entrée de la seconde structure de filtre et

$k_2 \cdot T_{a2}$ et/ou $(k_2-1) \cdot T_{a2}$ est le moment de balayage du signal d'entrée et du signal de sortie de la seconde structure de filtre.

6. Cascade de filtres numériques selon l'une quelconque des revendications 1 à 5,
   **caractérisée en ce**
   **que** la commutation de la première à la seconde structure de filtre du filtre suivant ($F_{IIR}$) est seulement validée dans le cas d'un signal d'entrée transitoire ($x_{IIR}(k_2 \cdot T_{a2}),x_{IIR}'(k_2 \cdot T_{a2})$) du filtre suivant ($F_{IIR}$).

7. Cascade de filtres numériques selon la revendication 6,
   **caractérisée en ce**
   **qu'**un signal de commande ($y_{FS}'(k_2 \cdot T_{a2})$) signale au filtre suivant ($F_{IIR}$) le moment auquel le signal d'entrée ($x_{IIR}(k_2 \cdot T_{a2})$, $x_{IIR}'(k_2 \cdot T_{a2})$) est transitoire.

8. Cascade de filtres numériques selon la revendication 7,
   **caractérisée en ce**
   **que** le filtre précédent ($F_{DEZ}$, $F_M$) de la cascade de filtres numériques se compose d'un filtre non décimant ou d'un filtre décimant, le filtre décimant se composant d'une commutation en série d'un filtre non décimant et d'un décimateur polyphasé.

9. Cascade de filtres numériques selon la revendication 8,
   **caractérisée en ce**
   **que** le filtre non décimant est un filtre FIR (Finite Impulse Response), un filtre IIR (Infinite Impulse Response) ou un filtre CIC (Cascaded Integrator Comb) avec une longueur de filtre respective L.

10. Cascade de filtres numériques selon la revendication 8 ou 9,
    **caractérisée en ce**
    **que** le décimateur polyphasé comporte des composants (p) polyphasés à transition optimisée et un coefficient de décimation (R).

11. Cascade de filtres numériques selon l'une quelconque des revendications 7 à 10,
    **caractérisée en ce**
    **qu'**une unité de génération du signal de commande (6, 6') détermine le moment du signal d'entrée transitoire ($x_{IIR}(k_2 \cdot T_{a2}),x_{IIR}'(k_2 \cdot T_{a2})$) du filtre suivant ($F_{IIR}$).dans le cas d'un signal d'entrée transitoire $x(k_0,T_{a0})$ de la cascade de filtres numériques en fonction de la longueur de filtre ($L_{DEZ}$, $L_M$) du filtre individuel non décimant et du coefficient de décimation ($R_{DEZ}$, $R_M$) et des composants polyphasés ($P_{DEZ}$, $P_M$) des décimateurs polyphasés individuels de la cascade de filtres numériques et génère le signal de commande ($Y_{FS}'(k_2 \cdot T_{a2})$) pour signaler le moment du signal d'entrée transitoire ($x_{IIR}(k_2 \cdot T_{a2}),x_{IIR}'(k_2 \cdot T_{a2})$) du filtre suivant ($F_{IIR}$).

12. Cascade de filtres numériques selon la revendication 11,
    **caractérisée en ce**
    **que** l'unité destinée à générer le signal de commande (6, 6') détermine le moment modifié du signal d'entrée transitoire ($x_{IIR}(k_2 \cdot T_{a2}),x_{IIR}'(k_2 \cdot T_{a2})$) du filtre suivant ($F_{IIR}$) dans le cas d'un recul du filtre non décimant et/ou des décimateurs polyphasés du filtre précédent ($F_{DEZ}$, $F_M$) de la cascade de filtres numériques et génère le signal de commande ($y_{FS}'(k_2 \cdot Ta_2)$) pour signaler le moment modifié du signal d'entrée transitoire ($X_{IIR}(k_2 \cdot T_{a2})$, $x_{IIR}'(k_2 \cdot T_{a2})$) du filtre suivant ($F_{IIR}$).

13. Cascade de filtres numériques selon l'une quelconque des revendications 1 à 12,
    **caractérisée en ce**
    **que** la commutation a lieu de la seconde à la première structure de filtre du filtre suivant ($F_{IIR}$) dès que le filtre IIR (Infinite Impulse Response) modifié de premier ordre a transité vers un moment de transition minimum ($S \cdot T_{a2}$), ($S$) correspondant au nombre minimum de moments de balayage.

14. Cascade de filtres numériques selon la revendication 13,
    **caractérisée en ce**

**que** le nombre minimum ($S_{min}$) de moments de balayage correspond à l'inverse entier ( $\left\lfloor \frac{1}{\lambda} \right\rfloor$ ) du coefficient de mémoire ($\lambda$).

Fig. 1 (Stand der Technik)

Betrags-und Leistungs-mittelung

IIR-Filter $h_{IIR}(k_2 \cdot T_{a2})$

Dezimations-Filter $h_M(k_1 \cdot T_{a1})$

Betrags-berechnung

Dezimations-Filter $h_{DEZ}(k_0 \cdot T_{a0})$

$R_{DEZ}, p_{DEZ}$

$R_M, p_M$

$\lambda$

$x_{DEZ}(k_0 \cdot T_{a0})$

$y_{DEZ}(k_1 \cdot T_{a1})$

$x_M(k_1 \cdot T_{a1})$

$x_{IIR}(k_2 \cdot T_{a2}) = y_M(k_2 \cdot T_{a2})$

$y_{IIR}(k_2 \cdot T_{a2})$

Fig. 2 (Stand der Technik)

FIR-Filter: $h(k_{in} \cdot T_{ain})$ Filterlänge L

Dezimator Dezimationsfaktor R Polyphasen-komponente p

$x(k_{in} \cdot T_{ain})$

$y(k_{in} \cdot T_{ain})$

$y(k_{out} \cdot T_{aout})$

$f_{a,in}$

$f_{a,out}$

$F_{IIR}$

$x_{IIR}(k_2 \cdot T_{a2})$ bzw. $x_{IIR}'(k_2 \cdot T_{a2})$    1    4    5    $y_{IIR}(k_2 \cdot T_{a2})$ bzw. $y_{IIR}'(k_2 \cdot T_{a2})$

$\lambda$

2

0

$\lambda$

R   $Z^{-1}$   3

## Fig. 3

Initialisierung

$N_c(0) = L-1$

$x_{FS}(k) = 1$
$\& \ N_c(k) > 0$
———————
$y_{FS}(k) = 0,$
$N_c(k+1) = N_c(k)-1$

$x_{FS}(k) = 0$
———————
$y_{FS}(k) = 0,$
$N_c(k+1) = L-1$

1

$x_{FS}(k) = 1$
$\& \ N_c(k) = 0$
———————
$y_{FS}(k) = 1$

$x_{FS}(k) = 0$
———————
$y_{FS}(k) = 0,$
$N_c(k+1) = L-1$

2

$x_{FS}(k) = 1$
———————
$y_{FS}(k) = 1$

## Fig. 5

Fig. 4

EP 1 780 891 B1

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 03019534 A